(19) Europäisches Patentamt
European Patent Office
Office européen des brevets

(11) **EP 3 974 758 B1**

(12) **EUROPEAN PATENT SPECIFICATION**

(45) Date of publication and mention
of the grant of the patent:
**12.02.2025 Bulletin 2025/07**

(21) Application number: **21193107.6**

(22) Date of filing: **25.08.2021**

(51) International Patent Classification (IPC):
***F28D 15/00*** *(2006.01)*

(52) Cooperative Patent Classification (CPC):
**G06F 1/203; F28D 15/0233; F28D 15/04;
H01L 23/427;** F28D 2021/0028; F28F 2225/00;
F28F 2270/00; G06F 2200/201

(54) **COOLING APPARATUS WITH TWO-TIER VAPOR CHAMBER**

KÜHLVORRICHTUNG MIT ZWEISTUFIGER DAMPFKAMMER

APPAREIL DE REFROIDISSEMENT AVEC CHAMBRE DE VAPEUR À DEUX NIVEAUX

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.09.2020 US 202017033518**

(43) Date of publication of application:
**30.03.2022 Bulletin 2022/13**

(73) Proprietor: **INTEL Corporation
Santa Clara, CA 95054 (US)**

(72) Inventors:
• **SHAIKH, Javed
560034 Bangalore (IN)**
• **RAJU, Prakash Kurma
560068 Bangalore (IN)**
• **DHANDAPANI, Kathiravan
560037 Bangalore (IN)**

(74) Representative: **Rummler, Felix et al
Maucher Jenkins
Seventh Floor Offices
Artillery House
11-19 Artillery Row
London SW1P 1RT (GB)**

(56) References cited:
**US-A1- 2019 348 345     US-B2- 10 622 282**

• **BANDYOPADHYAY SOUMYA ET AL: "A
Cascaded Multi-Core Vapor Chamber for Intra-
Lid Heat Spreading in Heterogeneous
Packages", 2020 19TH IEEE INTERSOCIETY
CONFERENCE ON THERMAL AND
THERMOMECHANICAL PHENOMENA IN
ELECTRONIC SYSTEMS (ITHERM), IEEE, 21 July
2020 (2020-07-21), pages 963 - 969,
XP033825401, DOI: 10.1109/
ITHERM45881.2020.9190576**

**EP 3 974 758 B1**

**Description**

TECHNICAL FIELD

This disclosure relates in general to the field of computer systems and, more particularly, to a cooling apparatus that includes a two-tier vapor chamber. A two-tier vapor chamber as defined in the preamble of claim 1 is known from BANDYOPADHYAY SOUMYA ET AL: "A Cascaded Multi-Core Vapor Chamber for Intra-Lid Heat Spreading in Heterogeneous Packages",2020 19TH IEEE INTERSOCIETY CONFERENCE ON THERMAL AND THERMOMECHANICAL PHENOMENA IN ELECTRONIC SYSTEMS (ITHERM), IEEE, 21 July 2020 (2020-07-21), pages 963-969.

BACKGROUND

Computer systems may utilize vapor chambers for thermal cooling of processors or chip packages containing processors (e.g., a system-on-chip (SoC) that includes a central processing unit (CPU), graphics processing unit (GPU), and/or another type of processor). Vapor chambers may utilize phase change phenomena inside a chamber to spread heat and reduce a junction temperature. In thin mobile devices, current vapor chamber designs may lead to higher than desired temperatures on an exterior surface of the device due to the relatively thin vertical stack dimension. In some cases, processor throttling may be needed to reduce such temperatures. However, this also causes reduced compute performance in the device.

BRIEF DESCRIPTION OF THE DRAWINGS

FIG. 1 illustrates a simplified view of an example stack for a mobile device.
FIG. 2 illustrates an example embodiment of a two-tier vapor chamber apparatus.
FIGS. 3A-3B illustrate another example embodiment of a two-tier vapor chamber apparatus.
FIGS. 4A-4B illustrate another example embodiment of a two-tier vapor chamber apparatus.
FIGS. 5A-5B illustrate simplified views of example mobile device stacks with air gaps between the cooling solution and the top layer.
FIG. 6 is a chart illustrating an example relationship between thermal conductivity of air versus pressure.
FIGS. 7A-7B Illustrate example hot spots for single- and two-tier cooling apparatuses, respectively.
FIG. 8 is a chart showing example performance differences for copper heat plate, single-tier vapor chamber, and two-tier vapor chamber cooling apparatuses.
FIG. 9 is a chart showing example performance differences for vacuum- and aerogel-based two-tier vapor chamber apparatuses.
FIG. 10 is a flow diagram showing an example process for manufacturing a two-tier vapor chamber cooling apparatus according to embodiments of the present disclosure.
FIGS. 11A-11G illustrate example steps during a manufacturing process for a two-tier vapor chamber cooling apparatus according to embodiments of the present disclosure.
FIG. 12 illustrates an example embodiment of an embedded two-tier vapor chamber apparatus.
FIGS. 13A-13B Illustrate example hot spots for single- and embedded two-tier cooling apparatuses, respectively.
FIG. 14 is a chart showing example performance differences for a single-tier vapor chamber apparatus and an embedded two-tier vapor chamber cooling apparatus.
FIG. 15 is an example illustration of a processor according to an embodiment.
FIG. 16 illustrates a computing system that is arranged in a point-to-point (PtP) configuration according to an embodiment.

Like reference numbers and designations in the various drawings indicate like elements.

DETAILED DESCRIPTION OF EXAMPLE EMBODIMENTS

In the following description, numerous specific details are set forth, such as examples of specific configurations, structures, architectural details, etc. in order to provide a thorough understanding of the present disclosure. It will be apparent, however, to one skilled in the art that these specific details need not be employed to practice embodiments of the present disclosure. In some instances, well known components or methods may be utilized, and such details haven't been described in detail in order to avoid unnecessarily obscuring embodiments of the present disclosure.

For certain computing devices, such as mobile computing devices (laptops, mobile phones, tablets, etc.), thin and light designs may be highly desired. Sustained performance of these systems can be limited by the "skin" temperature limits (e.g., ~45-46C), while the "turbo" performance (e.g., heavy compute scenarios) may be limited by the junction temperature of the chip package (e.g., a system-on-chip (SoC) or other type of chip that includes a processor device such as a central processing unit (CPU) or graphics processing unit (GPU)) (e.g., ~100C). Due to the thinner vertical stack heights of these devices, the "skin" may be heated beyond its limit before the junction temperature ($T_j$) limit is reached for sustained workloads (e.g., the thermal design power (TDP)). As used herein, "skin" may refer to an outer layer of a vertical device stack, such as, for example, a top glass layer or back cover layer of a mobile device (e.g., mobile phone or tablet). Further, sustained performance may refer to performance during long-term expected steady state power consumption (e.g., PL1), while turbo performance may refer to performance during short-term maximum power consumption (e.g., PL2).

Further, in thinner devices, a skin hot spot might not much depend on the type of thermal spreader (e.g., copper vs. heat pipe vs. vapor chamber) on the chip package, since in thinner systems, heat may travel toward the skin irrespective of spreading. Skin heating may be avoided by providing a thermal air gap between the thermal solution on top of the chip package and over the skin (e.g., glass/back cover). However, thicker air gaps increase the stack of the system (i.e., overall height) and may increase the $T_j$, which reduces the turbo performance capability of the package.

Vapor chambers may be utilized as effective solutions in passive device junction temperature cooling. Vapor chambers may utilize phase change phenomena inside the chamber to spread the heat and reduce the junction temperature (Tj). However, in current designs, the skin temperature ($T_{skin}$) may be approximately the same as with other solutions, such as copper spreaders or heat pipes.

Accordingly, embodiments of the present disclosure include a two-tier vapor chamber (2T-VC) structure, which may provide one or more benefits over current cooling solutions, including reduction of skin hotspots. A two-tier vapor chamber design may include two layers or tiers: (1) a thin vacuum layer (e.g., ~0.1-0.2mm thick) in a top region of the vapor chamber and (2) a second layer below the vacuum layer in which liquid charging is utilized. The two regions may be separated by a thin copper layer. In some embodiments not belonging to the invention, the top layer may be filled with an insulating material having a thermal conductivity less than air (e.g., an aerogel) rather than vacuum. The top chamber of the 2T-VC structure may help to reduce the skin temperature and thus increase the sustained capability (PL1 limits) of a system (in some cases by ~15-20%). In embodiments utilizing an aerogel insulating material in the top chamber, PL1 performance may be increased by 13% when compared to copper plate solutions, and by 11% compared to current vapor chamber structures. Further, for short bursts (e.g., ~5-10 sec), the turbo performance of the product with a 2T-VC structure may be increased by approximately 15-20% compared to mainstream copper spreader solutions, and may remain approximately the same as current vapor chamber structures.

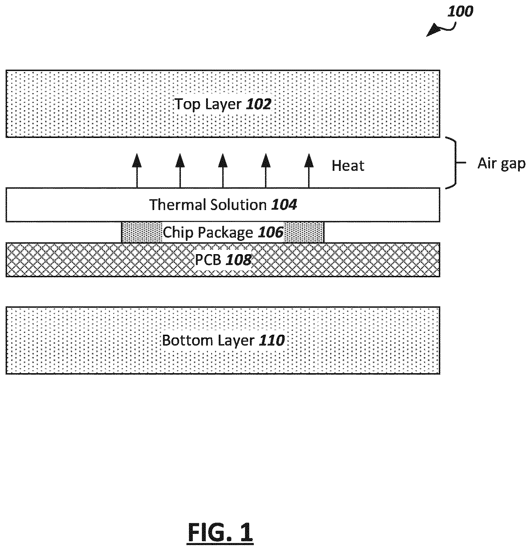

FIG. 1 illustrates a simplified view of an example stack 100 for a mobile device. The example stack 100 includes a top layer 102, thermal solution 104, chip package 106, printed circuit board (PCB) 108, and a bottom layer 110. The stack 100 may include additional layers than those shown. The top layer 102 and bottom layer 110 may be outer layers of the device. The top layer 102 may be formed of or include glass or another suitable material to provide an outer layer interface with a user, while the bottom layer may be formed of or include metal, plastic, or another suitable material for packaging the mobile device. The PCB 108 may be formed of an electrically insulating material, such as silicon, and may include one or more traces or other electrical components. The PCB 108 may house one or more chip packages (e.g., 106) that include processors, memory, or other computer components. In the example shown, the chip package 106 includes one or more processors (e.g., CPUs or GPUs). In some cases, the chip package 106 is a system-on-chip (SoC).

The thermal solution 104 removes heat generated by the chip package 106 during operation. In current systems, the thermal solution 104 may include a single-tier vapor chamber, heat pipe, or heat sink. However, in certain embodiments of the present disclosure, the thermal solution 104 includes a two-tier vapor chamber design as described herein. As shown, while the thermal solution 104 removes heat from the chip package 106, some of the heat may be dissipated from the thermal solution 104 into the air gap between the thermal solution 104 and the top layer 102, causing the top layer 102 to rise in temperature. The temperature in the top layer 102 may be referred to herein as the skin temperature ($T_{skin}$), while the temperature at the junction between the chip package 106 and the thermal solution 104 may be referred to as the junction temperature ($T_j$).

In certain systems (e.g., thin/light form factor devices, such as laptops or tablets, or high-performance computer systems, such as gaming systems), the sustained power capability may be limited by the skin temperature. As an example, the skin temperature limit of these systems may be approximately 45-48C while the junction temperature limit may be approximately 100C. A popular solution for reducing skin temperature is providing an air gap between the thermal solution 104 and the top layer 102 (due to low conductivity of air, which is ~0.026W/mK). The total air gap in the stack consists of two components, one is needed to maintain nominal air gap due to mechanical tolerance of the parts inside and another component is thermal requirement to meet the skin temperature limit (i.e., the air gap insulates the heat from the thermal solution 104 to reduce the skin temperature). While the air gap may provide an insulation layer and trap heat, thicker air gaps can undesirably increase the stack thickness and can increase the junction temperature, reducing the turbo performance capability of the chip package. In some cases, PL1 performance limitations of a device may be due to

$T_{skin}$ and might not depend much on the type of the thermal solution, while PL2 limitations may be due to junction temperature and may be dependent mainly on the effectiveness of the thermal solution used.

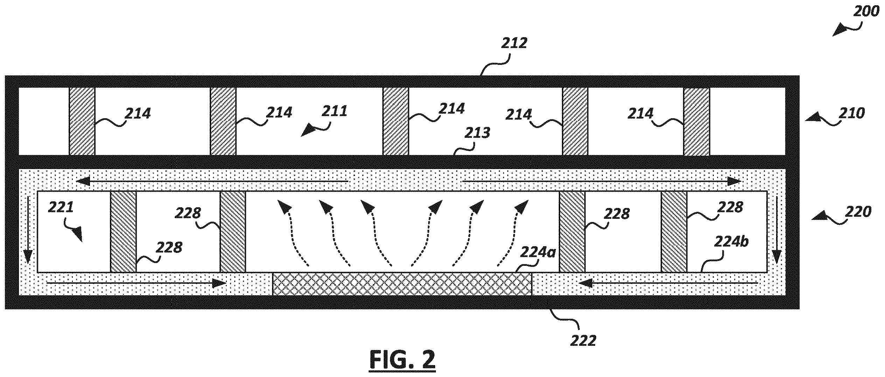

FIG. 2 illustrates an example embodiment of a two-tier vapor chamber apparatus 200. In particular, FIG. 2 illustrates a cross-sectional view of the apparatus. The example apparatus 200 includes two tiers 210, 220. The first tier 210 includes a sealed cavity 211 that is defined by the walls 212, 213. In some embodiments, the walls 212, 213 may be metal (e.g., copper, titanium, aluminum, alloy, or another thermally conductive metal). The first tier 210 also includes support structures 214 that are in contact with, and orthogonal to, the walls 212, 213 and may provide structural support for the cavity 211. The support structures 214 may be made of metal, plastic, graphite, or any other suitable material for providing structural support to the cavity 211. Further, the support structures 214 may be shaped or positioned in another manner than shown in FIG. 2.

The cavity 211 may be evacuated so that its internal pressure is less than the ambient pressure. For example, in some embodiments, the cavity 211 is evacuated to vacuum or near vacuum pressures, such as pressures less than 0.1 torr (e.g., 0.05-0.1 torr). In other embodiments, the cavity 211 is filled with a thermally insulating material having a thermal conductivity less than air, such as an aerogel. The vacuum or thermally insulating material in the cavity 211 may provide thermal insulation from other layers in a device stack (e.g., the top layer 102 of FIG. 1), which may reduce skin temperatures and provide one or more advantages as described above or otherwise herein.

The second tier 220 of the apparatus 200 includes a sealed cavity 221 that is defined by the walls 213, 222. In the example shown, the wall 222 is flat so that it may be positioned proximate to (or coupled to, via a thermal interface material (TIM)) a chip package to cool the chip package. The walls 212, 213 may be flat in certain areas, as shown in FIG. 2, or may have another shape. In certain embodiments, the components in the cavity 221 may function as a vapor chamber, whereby a liquid in the cavity 221 is heated by the chip package through wall 222 and evaporates into a vapor and then condenses as heat is dissipated from the vapor into the wall 213.

In the example shown, the interior surfaces of the cavity 221 (i.e., interior surfaces of walls 213, 222) include a wick material 224. The wick material 224 may include sintered metal (e.g., copper) or another type of material. The example wick material 224 includes two regions 224a, 224b. The region 224a may be considered as an evaporation/evaporator wick (e.g., may be the region of the wick in which evaporation of the liquid occurs), while the region 224b may be considered as a condensation/condenser wick (e.g., may be the region of the wick in which condensation (and flow as indicated by arrows in FIG. 2) of the liquid occurs). In some embodiments, the regions 224a, 224b may both be sintered metal, but may have different structures or porosities.

For example, in some embodiments, the region 224a may include a coarse graded mesh (e.g., with a porosity of between 40-70%, such as, for example, ~50-60%), while the region 224b may include a fine graded mesh (e.g., with a porosity between 30-50%, such as, for example, ~40-45%). The coarse graded mesh not only creates additional liquid-vapor interfaces for liquid vaporization, but also disturbs the temperature gradient in the liquid film to reduce the thermal resistance of saturated wicking structures and increases the evaporation rate across the interface. The total heat flux of the vapor chamber may accordingly be given by

$$Qmax = \dot{m}h_{fg}$$

where $\dot{m}$ is mass of evaporated liquid directly proportional to the interfacial surface area. Thus, the coarse graded mesh may help to increases the critical heat flux (CHF) capability of the two-tier vapor chamber. Further, fine graded mesh structure at the condenser wick area may produce higher capillary pressure for condensate flow back to evaporator portion. The capillary pressure of the evaporator wick may be given by

$$\Delta P_c = \frac{2\sigma}{R_{eff}}$$

where $\sigma$ is the surface tension of the working fluid, and $R_{eff}$ is the radius of curvature of the meniscus in the wick. Increasing the heat load to the evaporator increases the mass flow rate and the total pressure drop in the system which increase the overall HTC of the 2T-VC. With the above hybrid wick proposal (i.e., using wick portions having different porosities), based on the above equations, the thermal performance of the 2T-VC apparatus can be increased by 5-10% compared to a uniform wick material throughout the vapor chamber.

In the example shown, the cavity 221 also includes support structures 228, which may provide structural support to the cavity 221. The support structures 228 may be formed similar to the structures 214 in the cavity 211 or may be formed in a different manner.

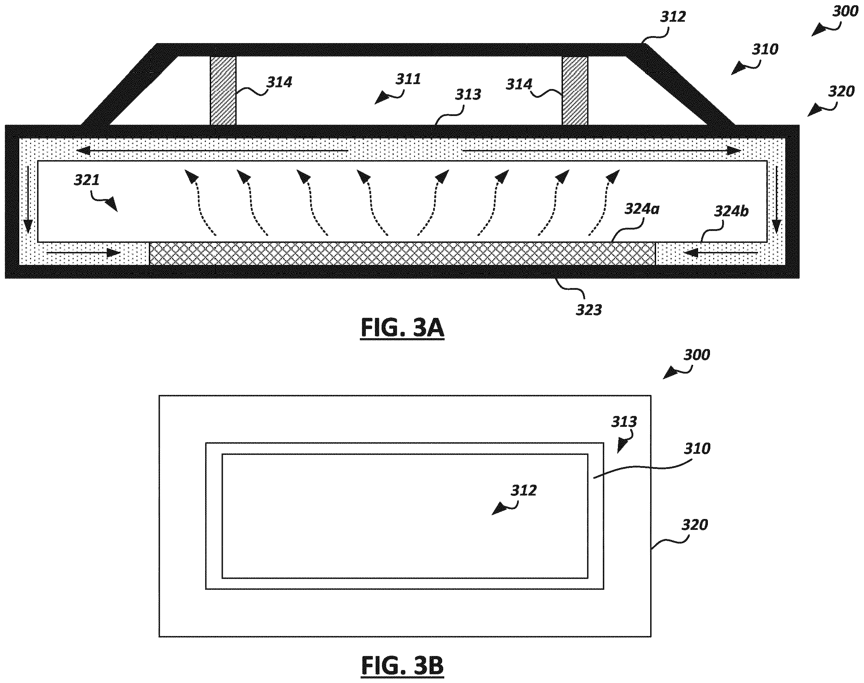

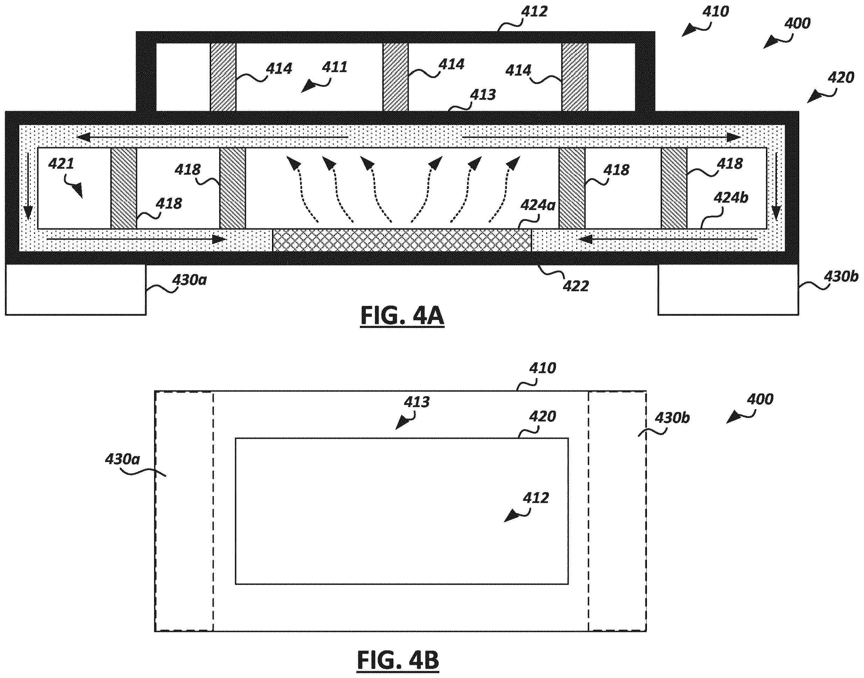

In the example shown, the cross-sectional areas of both cavities 211, 221 are rectangular. However, the cross-sectional areas of the cavities 211, 221 may be shaped in another manner (e.g., as shown in FIGS. 3A or 4A). Further, in the example shown, the cross-sectional areas of the cavities 211, 221 are substantially similar. However, the cross-sectional areas of the cavities 211, 221 may be different (e.g., as shown in FIGS. 3A, 3B).

FIGS. 3A-3B illustrate another example embodiment of a two-tier vapor chamber apparatus 300. In particular, FIG. 3A illustrates a cross-sectional view of the apparatus, while FIG. 3B illustrates a top view of the apparatus. Like the apparatus 200, the example apparatus 300 includes two tiers 310, 320. The first tier 310 includes a sealed cavity 311 that is defined by the walls 312, 313. In some embodiments, the walls 312, 313 may be metal (e.g., copper, titanium, aluminum, alloy, or another thermally conductive metal). The first tier 310 also includes support structures 314 that are in contact with, and orthogonal to, the walls 312, 313 and may provide structural support for the cavity 311. The support structures 314 may be made of metal, plastic, graphite, or any other suitable material for providing structural support to the cavity 311. Further, the support structures 314 may be shaped or positioned in another manner than shown in FIG. 3A.

The cavity 311 may be evacuated so that its internal pressure is less than the ambient pressure. According to the invention, the cavity 311 is evacuated to vacuum or near vacuum pressures, and configured with a pressure less than 0.1 torr (e.g., 0.05-0.1 torr). In other alternative embodiments not belonging to the invention, the cavity 311 is filled with a thermally insulating material having a thermal conductivity less than air, such as an aerogel. The vacuum or thermally insulating material in the cavity 311 may provide thermal insulation from other layers in a device stack (e.g., the top layer 102 of FIG. 1), which may reduce skin temperatures and provide one or more advantages as described above or otherwise herein.

The second tier 320 of the apparatus 300 includes a sealed cavity 321 that is defined by the walls 313, 322. In the example shown, the wall 322 is flat so that it may be positioned proximate to (or coupled to, via a TIM) a chip package to cool the chip package. The walls 312, 313 may be flat in certain areas, as shown in FIG. 3A, or may have another shape. In certain embodiments, the components in the cavity 321 may function as a vapor chamber, whereby a liquid in the cavity 321 is heated by the chip package through wall 322 and evaporates into a vapor and then condenses as heat is dissipated from the vapor into the wall 313.

In the example shown, the interior surfaces of the cavity 321 (i.e., interior surfaces of walls 313, 322) include a wick material 324. The wick material 324 may include sintered metal (e.g., copper) or another type of material. The example wick material 324 includes two regions 324a, 324b. The region 324a may be considered as an evaporation/evaporator wick (e.g., may be the region of the wick in which evaporation of the liquid occurs), while the region 324b may be considered as a condensation/condenser wick (e.g., may be the region of the wick in which condensation (and flow as indicated by arrows in FIG. 3A) of the liquid occurs). In some embodiments, the regions 324a, 324b may both be sintered metal, but may have different structures or porosities. For example, in some embodiments, the region 324a may include a coarse graded mesh (e.g., with a porosity of ~50-60%), while the region 324b may include a fine graded mesh (e.g., with a porosity of ~40-45%).

In the example shown, the cross-sectional area of the first cavity 311 is trapezoidal and the cross-sectional area of the second cavity 321 is rectangular. However, the cross-sectional areas of the cavities 311, 321 may be shaped in another manner. Further, in the example shown, the cross-sectional area of the cavity 311 is less than the cross-sectional area of the cavity 321.

FIGS. 4A-4B illustrate another example embodiment of a two-tier vapor chamber apparatus 400. In particular, FIG. 4A illustrates a cross-sectional view of the apparatus, while FIG. 4B illustrates a top view of the apparatus. Like the apparatuses 200 and 300, the example apparatus 400 includes two tiers 410, 420. The first tier 410 includes a sealed cavity 411 that is defined by the walls 412, 413. In some embodiments, the walls 412, 413 may be metal (e.g., copper, titanium, aluminum, alloy, or another thermally conductive metal). The first tier 410 also includes support structures 414 that are in contact with, and orthogonal to, the walls 412, 413 and may provide structural support for the cavity 411. The support structures 414 may be made of metal, plastic, graphite, composite material (e.g., carbon fiber) or any other suitable material for providing structural support to the cavity 411. Further, the support structures 414 may be shaped or positioned in another manner than shown in FIG. 4A.

The cavity 411 may be evacuated so that its internal pressure is less than the ambient pressure. For example, in some embodiments, the cavity 411 is evacuated to vacuum or near vacuum pressures, such as pressures less than 0.1 torr (e.g., 0.05-0.1 torr). In other embodiments, the cavity 411 is filled with a thermally insulating material having a thermal conductivity less than air, such as an aerogel. The vacuum or thermally insulating material in the cavity 411 may provide thermal insulation from other layers in a device stack (e.g., the top layer 102 of FIG. 1), which may reduce skin temperatures and provide one or more advantages as described above or otherwise herein.

The second tier 420 of the apparatus 400 includes a sealed cavity 421 that is defined by the walls 413, 422. In the example shown, the wall 422 is flat so that it may be positioned proximate to (or coupled to, via a TIM) a chip package to cool the chip package. The walls 412, 413 may be flat in certain areas, as shown in FIG. 4A, or may have another shape. In certain embodiments, the components in the cavity 421 may function as a vapor chamber, whereby a liquid in the cavity 421 is heated by the chip package through wall 422 and evaporates into a vapor and then condenses as heat is dissipated from the vapor into the wall 413.

In the example shown, the interior surfaces of the cavity 421 (i.e., interior surfaces of walls 413, 422) include a wick material 424. The wick material 424 may include sintered metal (e.g., copper) or another type of material. The example wick material 424 includes two regions 424a, 424b. The region 424a may be considered as an evaporation/evaporator wick (e.g., may be the region of the wick in which evaporation of the liquid occurs), while the region 424b may be considered as a condensation/condenser wick (e.g., may be the region of the wick in which condensation (and flow as indicated by arrows in FIG. 4A) of the liquid occurs). In some embodiments, the regions 424a, 424b may both be sintered metal, but may have different structures or porosities. For example, in some embodiments, the region 424a may include a coarse graded mesh (e.g., with a porosity of ~50-60%), while the region 424b may include a fine graded mesh (e.g., with a porosity of ~40-45%).

In the example shown, the cavity 421 also includes support structures 428, which may provide structural support to the cavity 421. The support structures 428 may be formed similar to the structures 414 in the cavity 411 or may be formed in a different manner.

In the example shown, the cross-sectional areas of the cavities 411, 421 are rectangular. However, the cross-sectional areas of the cavities 411, 421 may be shaped in another manner. Further, in the example shown, the cross-sectional area of the cavity 411 is less than the cross-sectional area of the cavity 421.

In some embodiments, the two-tier apparatus may be used in a passive cooling configuration where no other heat exchangers are used for cooling. However, in other embodiments, the two-tier apparatus may be used in an active cooling configuration that uses a heat exchanger (e.g., a fan) to aid in further cooling. For example, the open area across the vacuum chamber on the two-tier-apparatus may act to cool the vapor back to saturated liquid or sub cooled vapors while heat exchangers (e.g., 430) may be mounted on the back of the vapor chamber used for active cooling as condensers. For instance, in the example shown, heat exchangers 430 are positioned proximate to the vapor chamber of the tier 420. In particular, the heat exchangers 430 are positioned proximate to the outer portion of the exterior surface of the wall 422. In some embodiments, the heat exchangers may be positioned in an area of the exterior surface of the wall 422 that is outside the area of the wall 422 in which a chip package may be coupled (which may be, for example, vertically below the area of the top tier 410). The heat exchangers 430 may be positioned in another area of the apparatus 400 in other embodiments.

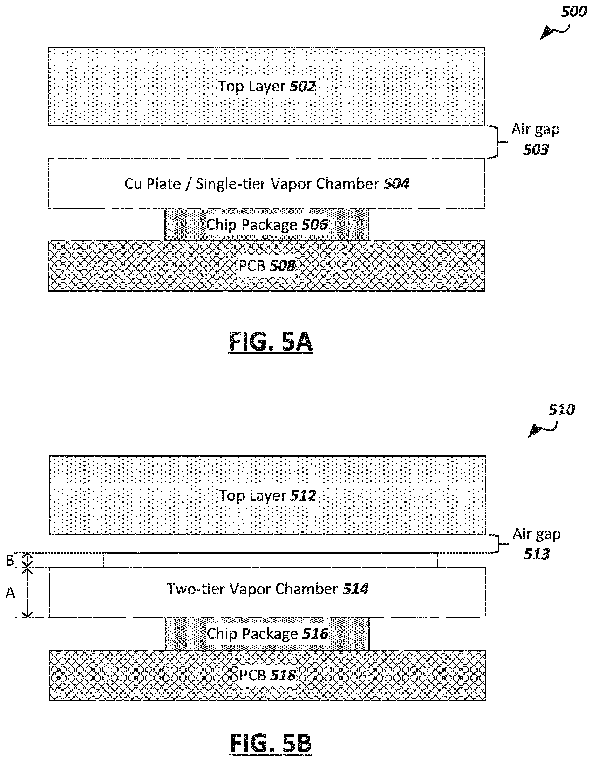

FIGS. 5A-5B illustrate simplified views of example mobile device stacks with air gaps between the cooling solution and the top layer. The stacks may include additional layers than those illustrated (e.g., may include one or more of the layers described in examples below). Referring to FIG. 5A, the example mobile device stack 500 includes a top layer 502, cooling apparatus 504, chip package 506, and PCB 508, which may all be similar to the top layer 102, thermal solution 104, chip package 106, and PCB 108 of FIG. 1, respectively. In the example shown in FIG. 5A, the cooling apparatus 504 is either a copper plate or single-tier vapor chamber cooling apparatus.

Referring to FIG. 5B, the example mobile device stack 510 includes a top layer 512, cooling apparatus 514, chip package 516, and PCB 518, which may all be similar to the top layer 102, thermal solution 104, chip package 106, and PCB 108 of FIG. 1, respectively. In the example shown in FIG. 5B, the cooling apparatus 514 is a two-tier vapor chamber apparatus, which may be formed similar to the example apparatuses described above with respect to FIGS. 2, 3A-3B, and 4A-4B, or otherwise as described herein.

In the examples shown in FIGS. 5A-5B, the space between the chip package and the top layer may be the same. However, the total thickness of the cooling apparatuses may be different. For instance, in one example, the air gap 503 may have a thickness of approximately 0.8 mm and the cooling apparatus 504 may have a thickness of approximately 0.5 mm, while the air gap 513 may have a thickness of approximately 0.5 mm and the cooling apparatus 514 may have a thickness (A + B in FIG. 5B) of approximately 0.8 mm. The thicknesses of each tier of the two-tier cooling apparatus (i.e., the thicknesses A and B in FIG. 5B) may be the same or different. For instance, in the example described above, each tier of the two-tier cooling apparatus may be approximately 0.4 mm. In some instances, the two-tier cooling apparatus may be formed such that the lower tier has a total thickness of 0.4 mm (i.e., the thickness A in FIG. 5B), while the top tier has top metal wall thickness of 0.2mm and a cavity thickness of 0.2 mm. Thus, in some embodiments, the total stack height may remain the same as with conventional cooling techniques, as the increased thickness of the two-tier cooling apparatus may be compensated for by a reduced air gap thickness (while still meeting thermal requirements).

### *Simulation and Testing*

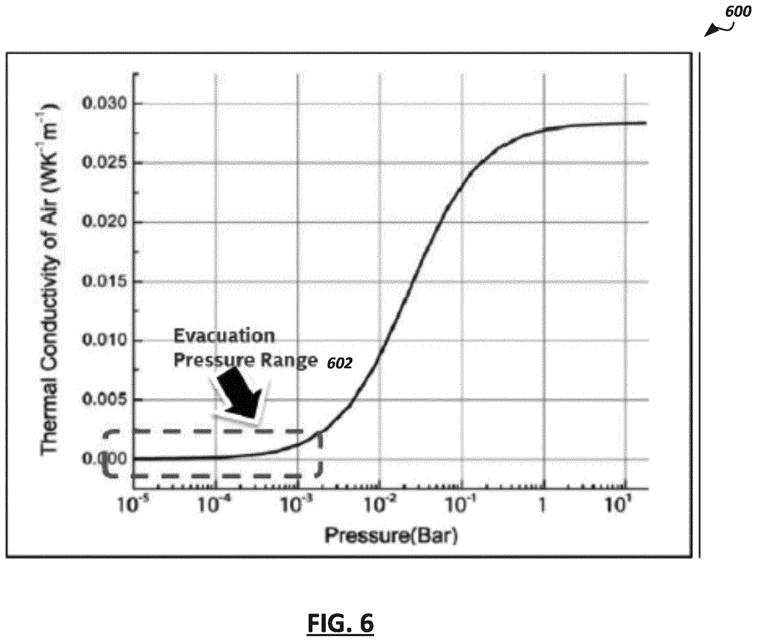

In the following models, the vacuum is modeled as low conductivity object with radiation. The conductivity value depends on the evacuation pressure maintained in the chamber before liquid charging phase. In the modeling used herein, conductivity values are taken form 0.005 W/mk to 0.001W/mK based on an evacuation range of 0.05-0.1 torr of air pressure, while emissivity is taken as 0.9 to capture radiation in vacuum. FIG. 6 is a chart 600 illustrating an example relationship between thermal conductivity of air versus pressure. In some embodiments, the evacuation pressure for the top tier cavity may be selected in the example evacuation pressure range 602 indicated in FIG. 6.

The following example device stacks are used in the models described below. The example stack layers are listed in Tables 1-2 in their vertical order, whereby the first item listed is the top layer of the stack and the last item listed is the bottom layer of the stack. As is shown by Tables 1-2, the total stack thickness is the same in each case, but the top air gap and cooling apparatus thicknesses differ.

Table 1: First Example Device Stack

| Component | Thickness (mm) |
|---|---|
| Glass (top layer) | 0.4 |
| OCA | 0.2 |
| Display | 1.65 |
| Aluminum LCD plate | 0.3 |
| Graphite | 0.09 |
| Air gap (top) | 0.8 |
| Copper Plate / Single-tier vapor chamber apparatus | 0.5 |
| TIM | 0.15 |
| Chip package | .08 |
| Solder paste | 0.1 |
| PCB | 0.6 |
| Graphite | 0.09 |
| Air Gap (bottom) | 0.5 |
| Graphite | 0.09 |
| Aluminum enclosure (bottom layer) | 0.8 |
| **Total** | **7.07** |

Table 2: Second Example Device Stack

| Component | Thickness (mm) |
|---|---|
| Glass (top layer) | 0.4 |
| OCA | 0.2 |
| Display | 1.65 |
| Aluminum LCD plate | 0.3 |
| Graphite | 0.09 |
| Air gap (top) | 0.5 |
| Two-tier vapor chamber apparatus | 0.8 |
| TIM | 0.15 |
| Chip package | .08 |
| Solder paste | 0.1 |
| PCB | 0.6 |
| Graphite | 0.09 |
| Air Gap (bottom) | 0.5 |
| Graphite | 0.09 |
| Aluminum enclosure (bottom layer) | 0.8 |
| **Total** | **7.07** |

The simulation results shown in Table 3 are based on PL1=7W (TDP) and PL2=10W (1CT) for 5 sec. The thermal simulations were performed for three different thermal solutions i.e. (A) 0.5mm copper plate with 0.8 mm air gap, (B) 0.5mm single-tier vapor chamber (VC) apparatus with 0.8 mm air gap, (C) 0.8 mm two-tier VC (2T-VC) with 0.5 mm air gap, and (D) 0.8 mm 2T-VC with 0.5 mm air gap, but where the area of the top tier vacuum chamber is reduced by 15% from (C).

Table 3: Example Simulation Results

| | Copper Plate (A) | Single-Tier VC (B) | Two-Tier VC (C) | Two-Tier VC with reduced vacuum region (D) |
|---|---|---|---|---|
| $T_{top}$, glass | 43.1 | 43.1 | 40.3 | 40.6 |
| $T_j$ | 96.5 | 78.7 | 84.13 | 79.82 |
| $T_{chassis}$ | 39.6 | 40.6 | 40.4 | 40.2 |
| PL1 capability | 7.6 | 7.7 | 8.9 | 8.8 |
| % change | Base | 2.2 | 21.7 | 19 |
| $T_j$(5 sec) | 57.2 | 50.4 | 51.1 | 51.2 |
| PL2 capability | 16.3 | 20.7 | 20.1 | 20 |
| % change | Base | 26.8 | 23.4 | 22.9 |

As shown in Table 3, the PL1 capability of the copper plate is slightly less than a single-tier VC of the same size and thickness, since the system is limited by skin temperature. However, the Tj is reduced by ~18C in the single-tier VC case and spreads the hot spot on its surface which gives ~0.4C reduction in top cover temperature for VC. In the case of the first 2T-VC (C), the skin temperature is reduced by ~3C due to resistance created by vacuum layer in the path of heat transfer from 2T-VC to the skin, which helps to increase PL1 limit by ~15% compared to the copper plate and single-tier VC. Turning to the second 2T-VC (D), the increase in Tj may be mitigated by optimizing the system, e.g., providing thicker graphite below the PCB and/or using vacuum chamber only above the core region (e.g., reducing the vacuum size by 15%).

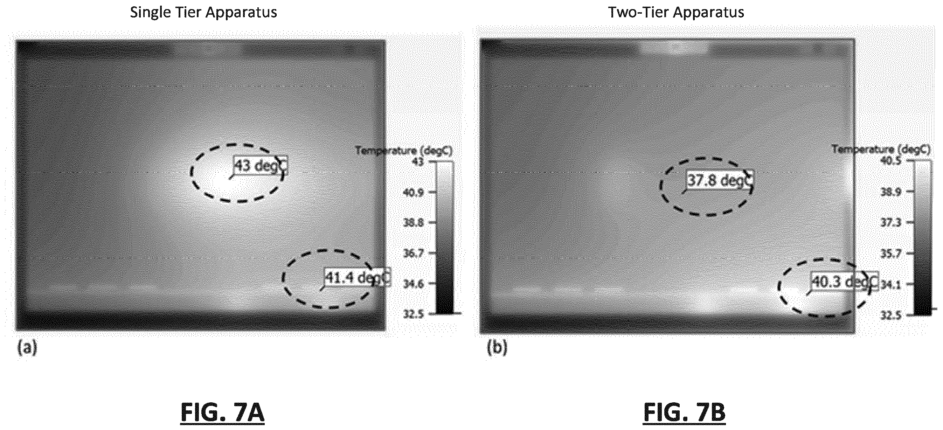

FIGS. 7A-7B Illustrate example hot spots for single- and two-tier cooling apparatuses, respectively. As shown in FIGS. 7A-7B, the main hotspot location is shifted to the bottom-right side of the chart (as indicated by the dotted ovals), where heat is emitted from an LED panel rather than a chip package, since the hotspot related to the chip package (in the relative middle of the charts) is reduced. In the example shown, PL1 capability is increased approximately 20-25%.

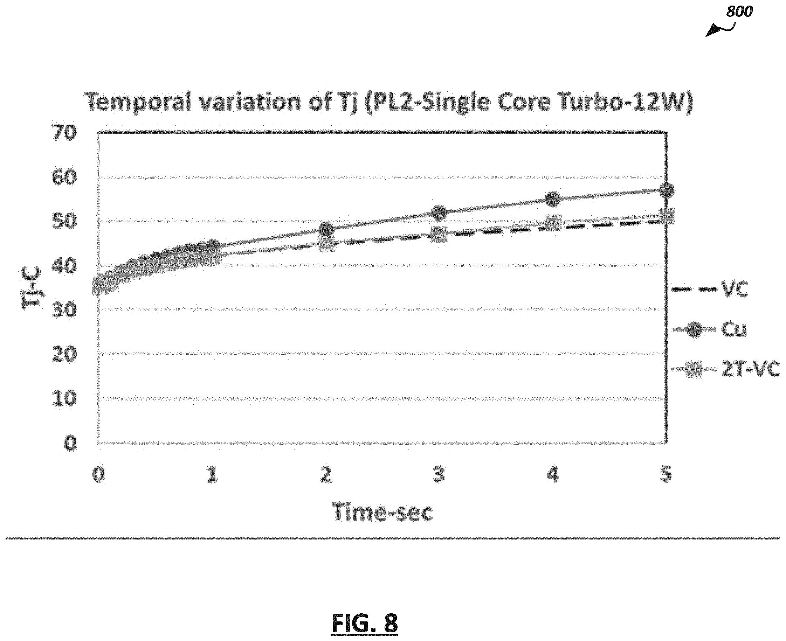

FIG. 8 is a chart 800 showing example performance differences for copper heat plate apparatus ("Cu" in the chart), single-tier vapor chamber apparatus ("VC" in the chart), and two-tier vapor chamber cooling apparatus ("2T-VC" in the chart). As shown, the PL2 capability for 5sec is almost the same for single-tier VC and 2T-VC configurations, which are increased by ~23% compared to the copper plate configuration (e.g., due to better capacitance of phase change inside in the vapor chamber).

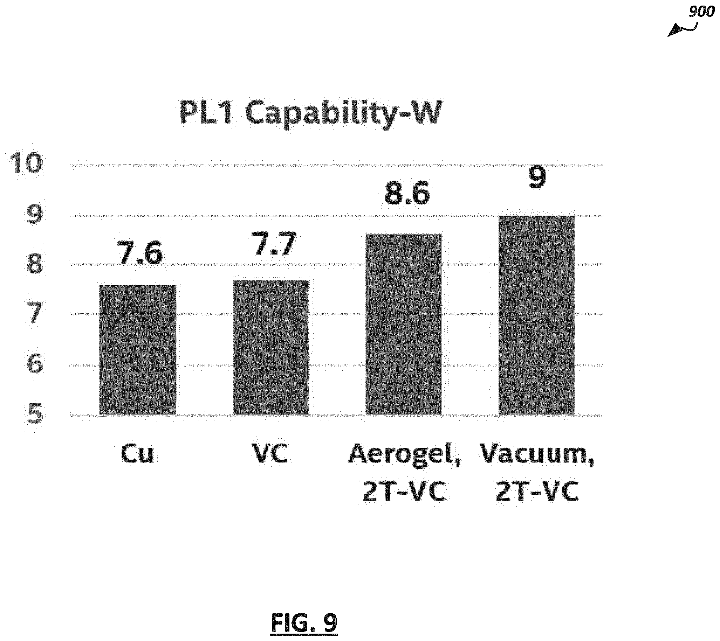

FIG. 9 is a chart 900 showing example performance differences for vacuum- and aerogel-based two-tier vapor chamber apparatuses. Table 4 also illustrates such performance differences, based on aerogel properties of k = 0.017 W/mK and e = 0.9 (GORE data).

Table 4: Performance differences for vacuum- and aerogel-based 2T-VCs

| Thermal Solution | $T_{skin}$ (C) | PL1 Capability |
|---|---|---|
| Copper heat plate | 43.5 | 7.6 |
| Single-tier VC | 43.1 | 7.7 |
| Aerogel-based 2T-VC | 41.9 | 8.6 |
| Vacuum-based 2T-VC | 40.3 | 9.2 |

In some embodiments, the Aerogel conductivity may lie in the range of 0.016-0.018 W/mK, so the thermal resistance may be less for aerogel-based 2T-VCs as compared to vacuum-based 2T-VCs, but still more than air. As shown, the top glass temperature is 41.9C for the aerogel-based 2T-VC as compared to 40.5C for the vacuum-based 2T-VC. The PL1 performance of the aerogel-based 2T-VC increased by 13% compared to the copper plate and by 11% compared to the single-tier VC.

In some embodiments, the walls of each tier may be composed of different metals. In some embodiments, the top wall of the apparatus (e.g., 212 of FIG. 2) may be the same metal as the bottom tier walls (e.g., 213, 222 of FIG. 2). However, in other embodiments, the top wall of the apparatus (e.g., 212 of FIG. 2) may be a different metal as the bottom tier walls (e.g., 213, 222 of FIG. 2). The metal choice may depend on implementation details, including cost constraints or thickness constraints. Example junction temperatures ($T_j$), skin temperatures ($T_{skin}$), apparatus thicknesses, and relative costs are shown below in Table 5. As shown, use of Titanium in certain walls may provide a lower overall apparatus thickness and lower $T_j$, but at a higher cost and with higher $T_{skin}$. Another type of metal, such as aluminum or alloy, may be used in other embodiments.

Table 5: Example Measurements for Copper and Titanium Wall Metal Choices

| | Top wall: Copper Bottom tier walls: Copper | Top wall: Titanium Bottom tier walls: Titanium | Top wall: Titanium Bottom tier walls: Copper |
|---|---|---|---|
| Thermal performance ($T_j$ / $T_{skin}$) | 40.7 C / 93.4 C | 40.3 C / 96 C | 40.3 C / 95 C |
| Thickness of 2T-VC | 0.5-0.8 mm | 0.3-0.5 mm | 0.3-0.5 mm |
| Relative cost | Base | Higher | Higher |

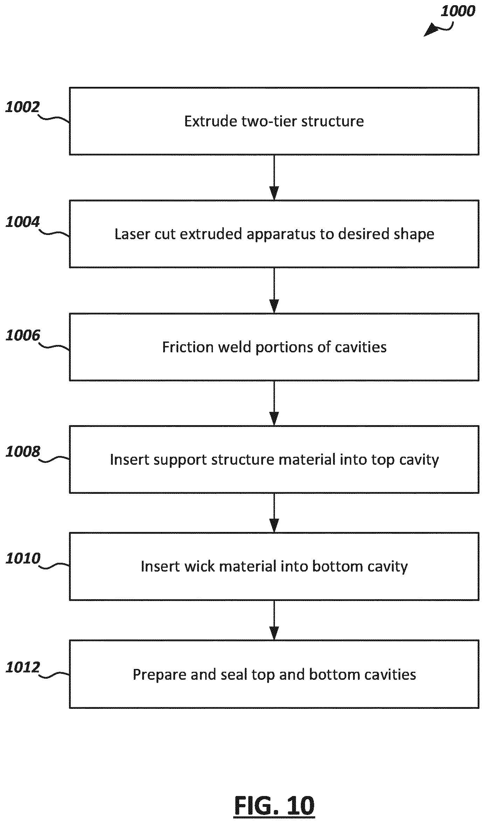

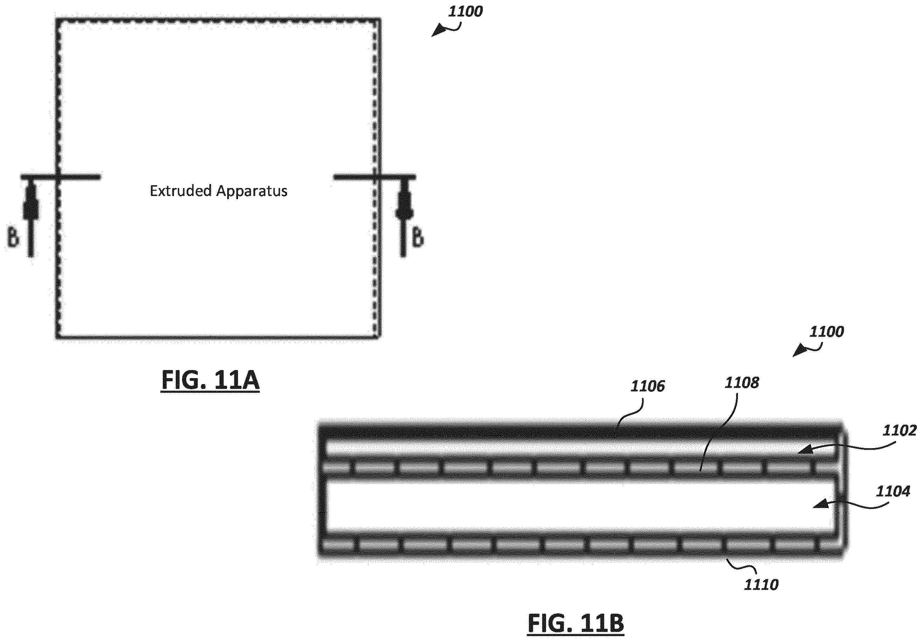

FIG. 10 is a flow diagram showing an example process 1000 for manufacturing a two-tier vapor chamber cooling apparatus according to embodiments of the present disclosure, and FIGS. 11A-11G illustrate example steps during the manufacturing process 1000. The example process may include additional or different operations, and the operations may be performed in the order shown or in another order. In some cases, one or more of the operations shown in FIG. 10 are implemented as processes that include multiple operations, sub-processes, or other types of routines. In some cases, operations can be combined, performed in another order, performed in parallel, iterated, or otherwise repeated or performed another manner.

At 1002, a metal is extruded to form an apparatus that includes a first cavity defined (at least partially) by a first wall and a second wall, and a second cavity defined (at least partially) by the second wall and a third wall. For example, referring to FIGS. 11A-11B, the extruded apparatus 1100 includes a first cavity 1102 and a second cavity 1104. The first cavity 1102 is defined by the wall 1106 and wall 1108, while the second cavity is defined by the wall 1108 and the wall 1110. Although a particular cross-sectional profile is shown in FIG. 11B, other cross-sectional profiles may be extruded (e.g., those shown in FIGS. 2, 3B, and 4B).

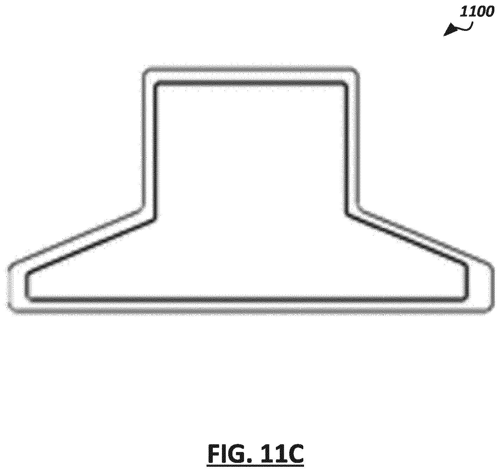

At 1004, the extruded apparatus is cut to the desired shape. For instance, referring to the example shown in FIG. 11C (a top view of the apparatus 1100), the apparatus 1100 is cut to the shape shown. The cutting may be performed using a laser cutting process, in some embodiments.

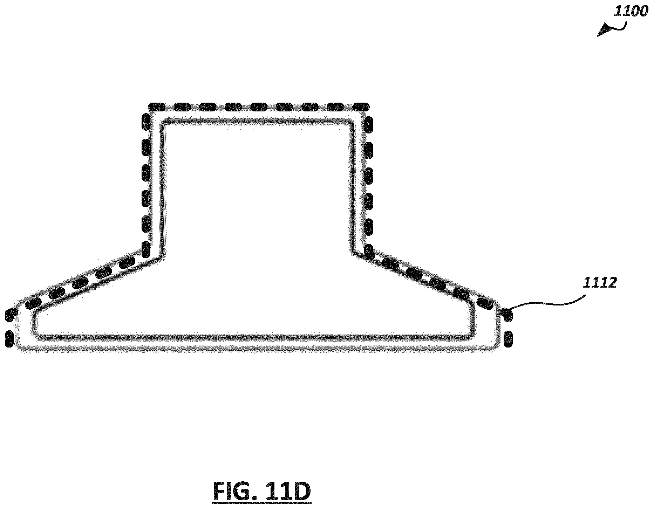

At 1006, the cavities of the apparatus are partially sealed, e.g., via friction welding. For instance, referring to the example shown in FIG. 11D, the apparatus 1100 is welded along the dotted line 1112 to partially seal the cavities of the apparatus.

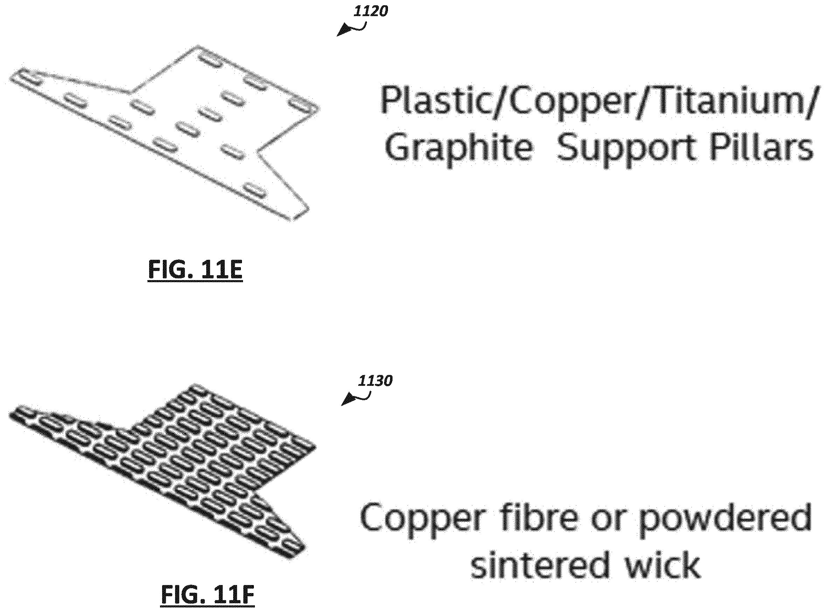

At 1008, a support structure apparatus is inserted into a first cavity of the apparatus. The support structure apparatus may be formed of plastic, graphite, metal, composite material (e.g., carbon fiber) or another type of material. As an example, the support structure apparatus may be formed similar to the example support structure apparatus 1120 shown in FIG. 11E, which may be inserted into the top cavity of the cut and welded apparatus 1100 shown in FIG. 11D.

At 1010, wick material is inserted into a second cavity of the apparatus. The wick material may include sintered metal, copper fiber, or other types of wick material. In some cases, the wick material may be formed on a prefabricated wick structure that is to be inserted into the cut and welded extruded apparatus. For example, the wick material may be formed on a prefabricated structure similar to the example apparatus 1130 shown in FIG. 11F, which may be inserted into the bottom cavity of the cut and welded apparatus 1100 shown in FIG. 11D. In some cases, additional preparation steps (e.g., heating) may be needed to prepare the wick material once the apparatus 1130 is inserted.

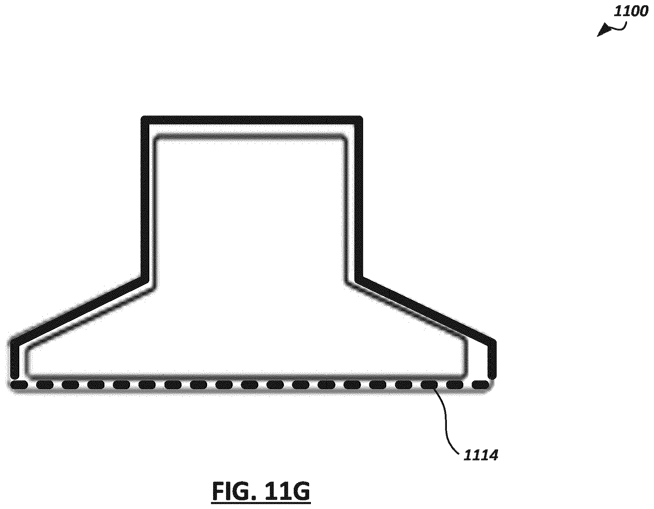

At 1012, the top and bottom cavities of the apparatus are prepared and sealed. In some cases, preparation of the top cavity may include aerogel insertion or air evacuation (to create a vacuum), while preparation of the bottom cavity may include insertion of a liquid to be used in the vapor chamber. Once the cavities are prepared, they may be fully sealed, such as, via further friction welding. For instance, referring to the example shown in FIG. 11G, the apparatus 1100 may be welded along the dotted line 1114 to fully seal the cavities of the apparatus. Following the sealing process, the apparatus may be tested, inspected, and/or quality checked prior to use (e.g., mounting in a device stack to cool a chip package).

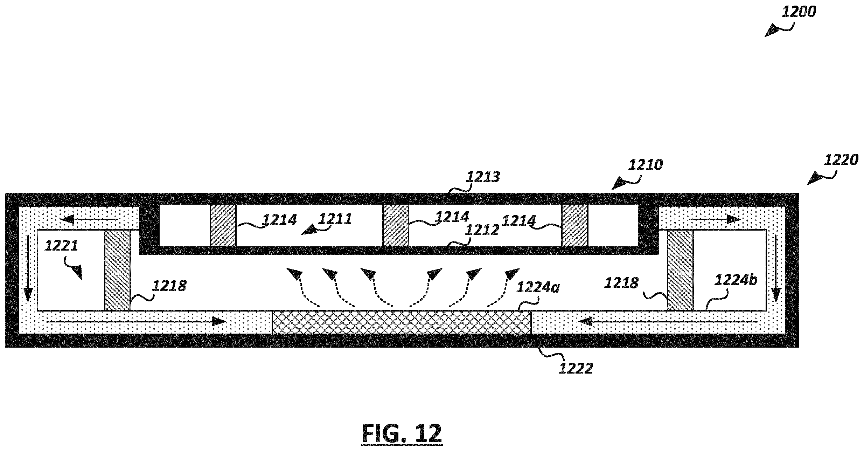

FIG. 12 illustrates an example embodiment of an embedded two-tier vapor chamber apparatus 1200. In particular, FIG. 12 illustrates a cross-sectional view of the apparatus 1200. Like the apparatus 400 of FIG. 4A, the example apparatus 1200 includes two tiers 1210, 1220. However, the sealed cavity 1211 of the tier 1210 is disposed within the cavity 1221 of the tier 1220, whereas the cavity 411 is outside the cavity 421 in the example apparatus 400.

The sealed cavity 1211 is defined by the walls 1212, 1213. In some embodiments, the walls 1212, 1213 may be metal (e.g., copper, titanium, aluminum, alloy, or another thermally conductive metal). The sealed cavity includes support structures 1214 that are in contact with, and orthogonal to, the walls 1212, 1213 and may provide structural support for the cavity 1211. The support structures 1214 may be made of metal, plastic, graphite, composite material (e.g., carbon fiber) or any other suitable material for providing structural support to the cavity 1211. Further, the support structures 1214 may be shaped or positioned in another manner than shown in FIG. 12.

The cavity 1211 may be evacuated so that its internal pressure is less than the ambient pressure (either within the cavity 1221 or outside the apparatus 1200). For example, in some embodiments, the cavity 1211 is evacuated to vacuum or near vacuum pressures, such as pressures less than 0.1 torr (e.g., 0.05-0.1 torr). In other embodiments, the cavity 1211 is filled with a thermally insulating material having a thermal conductivity less than air, such as an aerogel. The vacuum or thermally insulating material in the cavity 1211 may provide thermal insulation from other layers in a device stack (e.g., the top layer 102 of FIG. 1), which may reduce skin temperatures and provide one or more advantages as described above or otherwise herein.

The second tier 1220 of the apparatus 1200 includes a sealed cavity 1221 that is defined by the walls 1213, 1222. In the example shown, the wall 1222 is flat so that it may be positioned proximate to (or coupled to, via a TIM) a chip package to cool the chip package. The walls 1212, 1213 may be flat in certain areas, as shown in FIG. 12, or may have another shape. In certain embodiments, the components in the cavity 1221 may function as a vapor chamber, whereby a liquid in the cavity 1221 is heated by the chip package through wall 1222 and evaporates into a vapor and then condenses as heat is dissipated from the vapor into the wall 1213.

In the example shown, the interior surfaces of the cavity 1221 (i.e., interior surfaces of walls 1213, 1222) include a wick material 1224. The wick material 1224 may include sintered metal (e.g., copper) or another type of material. The example wick material 1224 includes two regions 1224a, 1224b. The region 1224a may be considered as an evaporation/evaporator wick (e.g., may be the region of the wick in which evaporation of the liquid occurs), while the region 1224b may be considered as a condensation/condenser wick (e.g., may be the region of the wick in which condensation (and flow as indicated by arrows in FIG. 12) of the liquid occurs). In some embodiments, the regions 1224a, 1224b may both be sintered metal, but may have different structures or porosities. For example, in some embodiments, the region 1224a may include a coarse graded mesh (e.g., with a porosity of ~50-60%), while the region 1224b may include a fine graded mesh (e.g., with a porosity of ~40-45%).

In the example shown, the cavity 1221 also includes support structures 1228, which may provide structural support to the cavity 1221. The support structures 1228 may be formed similar to the structures 1214 in the cavity 1211 or may be formed in a different manner.

In the example shown, the cross-sectional areas of the cavities 1211, 1221 are rectangular. However, the cross-sectional areas of the cavities 1211, 1221 may be shaped in another manner. Further, in the example shown, the cross-sectional area of the cavity 1211 is less than the cross-sectional area of the cavity 1221.

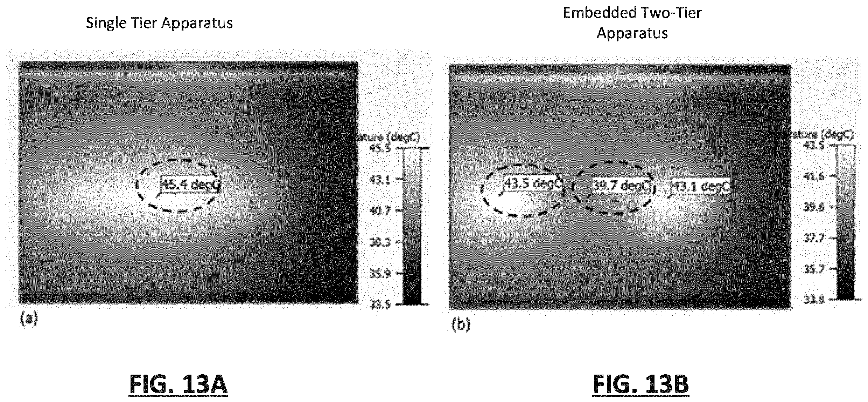

FIGS. 13A-13B Illustrate example hot spots for single- and embedded two-tier cooling apparatuses, respectively. As shown in FIGS. 13A-13B, the main hotspot location is shifted (as indicated by the dotted ovals), since the hotspot related to the chip package (in the relative middle of the charts) is reduced. In the example shown, PL1 capability is increased approximately 15-20%.

An embedded structure as shown in FIG. 12 may be utilized to gain one or more of the advantages of the two-tier apparatus described above while maintaining a similar or the same stack height as a single tier cooling apparatus. Example simulation results for the two scenarios are shown below in Table 6.

Table 6: Example Simulation Results

|  | Protruded 2T-VC | | Embedded 2T-VC | |
|---|---|---|---|---|
|  | 1VC | 2T-VC | 1VC | 2T-VC |
| Ttop, glass | 43.1 | 40.6 | 45.4 | 43.3 |
| Tj | 78.7 | 79.9 | 82.2 | 86.9 |
| Tchassis | 40.6 | 40.2 | 45.2 | 45.4 |
| PL1 Capability | 7.7 | 9.0 | 10.3 | 11.5 |
| % Change | Base | 16.0 | Base | 11.5 |
| Tj | 50.4 | 51.1 | 94.2 | 94.9 |
| PL2 Capability | 20.7 | 20.1 | 21.7 | 21.5 |
| % Change | Base | 2.7 | Base | 1.1 |

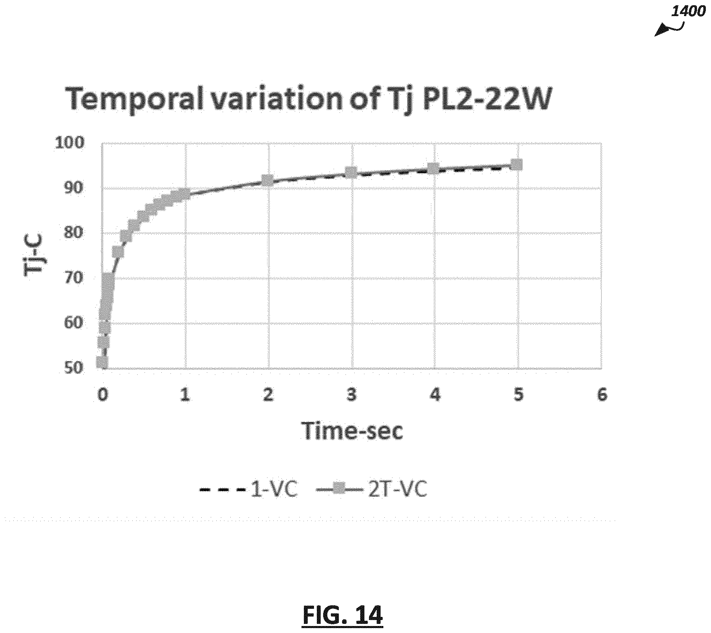

FIG. 14 is a chart 1400 showing example performance differences for a single-tier vapor chamber apparatus ("1-VC" in the chart) and an embedded two-tier vapor chamber cooling apparatus ("2T-VC" in the chart). As shown, the PL2 capability for 5sec is almost the same for single-tier VC and embedded 2T-VC configurations.

A similar process to that described above with respect to FIGS. 10-11 may be used to manufacture an embedded two-tier VC apparatus.

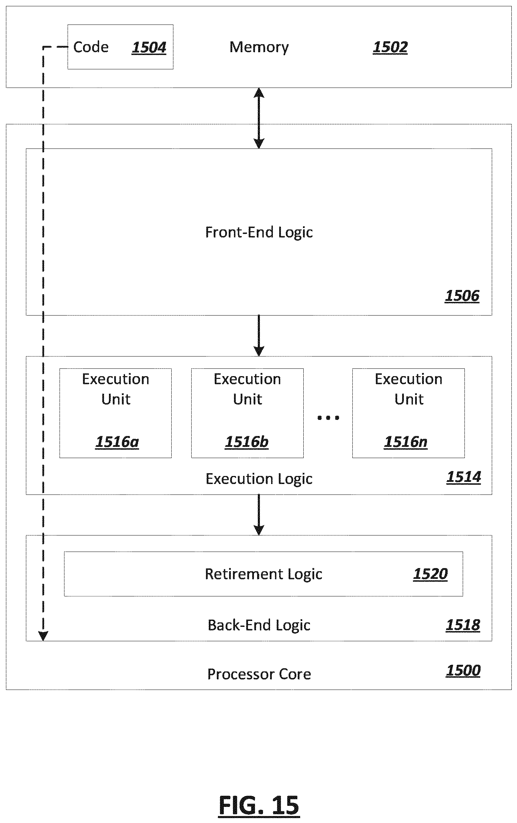

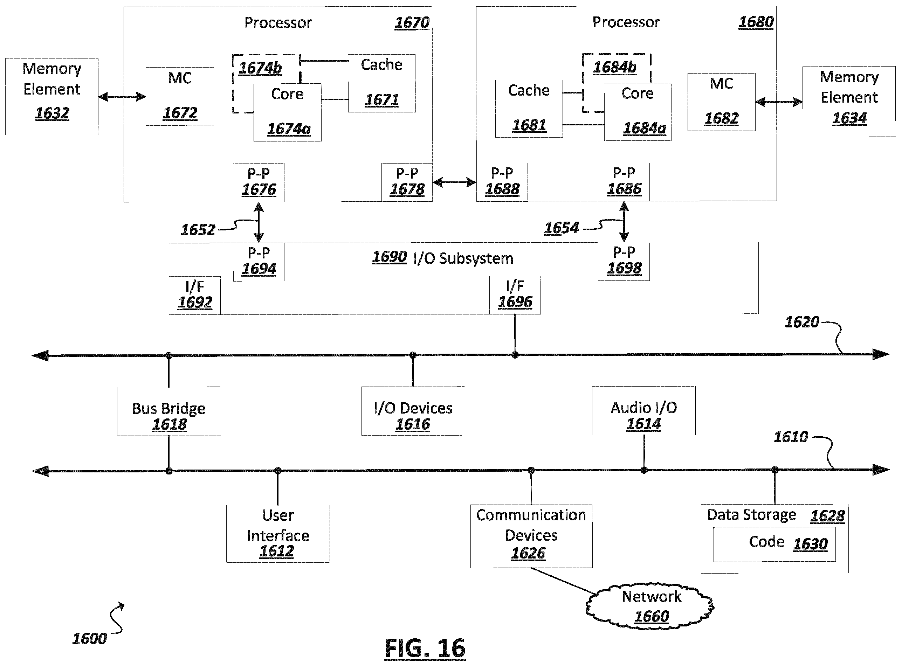

FIGS. 15-16 are block diagrams of example computer architectures that may be used in accordance with embodiments disclosed herein. For example, in some embodiments, a two-tier vapor chamber apparatus as described above may be used to cool a chip package, such as a SoC, containing one or more aspects shown in FIGS. 15-16 (e.g., the processor core 1500 of FIG. 15 or one or both of processors 1670, 1680 of FIG. 16). In some embodiments, the computer architecture may be implemented within a mobile device system, such as a mobile phone or table computer system. Other computer architecture designs known in the art for processors and computing systems may also be used. Generally, suitable computer architectures for embodiments disclosed herein can include, but are not limited to, configurations illustrated in FIGS. 15-16.

FIG. 15 is an example illustration of a processor according to an embodiment. Processor 1500 is an example of a type of hardware device that can be used in connection with the implementations above. Processor 1500 may be any type of processor, such as a microprocessor, an embedded processor, a digital signal processor (DSP), a network processor, a multi-core processor, a single core processor, or other device to execute code. Although only one processor 1500 is illustrated in FIG. 15, a processing element may alternatively include more than one of processor 1500 illustrated in FIG. 15. Processor 1500 may be a single-threaded core or, for at least one embodiment, the processor 1500 may be multi-threaded in that it may include more than one hardware thread context (or "logical processor") per core.

FIG. 15 also illustrates a memory 1502 coupled to processor 1500 in accordance with an embodiment. Memory 1502 may be any of a wide variety of memories (including various layers of memory hierarchy) as are known or otherwise available to those of skill in the art. Such memory elements can include, but are not limited to, random access memory (RAM), read only memory (ROM), logic blocks of a field programmable gate array (FPGA), erasable programmable read only memory (EPROM), and electrically erasable programmable ROM (EEPROM).

Processor 1500 can execute any type of instructions associated with algorithms, processes, or operations detailed herein. Generally, processor 1500 can transform an element or an article (e.g., data) from one state or thing to another state or thing.

Code 1504, which may be one or more instructions to be executed by processor 1500, may be stored in memory 1502, or may be stored in software, hardware, firmware, or any suitable combination thereof, or in any other internal or external component, device, element, or object where appropriate and based on particular needs. In one example, processor 1500 can follow a program sequence of instructions indicated by code 1504. Each instruction enters a front-end logic 1506 and is processed by one or more decoders 1508. The decoder may generate, as its output, a micro operation such as a fixed width micro operation in a predefined format, or may generate other instructions, microinstructions, or control signals that reflect the original code instruction. Front-end logic 1506 also includes register renaming logic 1510 and scheduling logic 1512, which generally allocate resources and queue the operation corresponding to the instruction for execution.

Processor 1500 can also include execution logic 1514 having a set of execution units 1516a, 1516b, 1516n, etc. Some embodiments may include a number of execution units dedicated to specific functions or sets of functions. Other embodiments may include only one execution unit or one execution unit that can perform a particular function. Execution logic 1514 performs the operations specified by code instructions.

After completion of execution of the operations specified by the code instructions, back-end logic 1518 can retire the instructions of code 1504. In one embodiment, processor 1500 allows out of order execution but requires in order retirement of instructions. Retirement logic 1520 may take a variety of known forms (e.g., re-order buffers or the like). In this manner, processor 1500 is transformed during execution of code 1504, at least in terms of the output generated by the decoder, hardware registers and tables utilized by register renaming logic 1510, and any registers (not shown) modified by execution logic 1514.

Although not shown in FIG. 15, a processing element may include other elements on a chip with processor 1500. For example, a processing element may include memory control logic along with processor 1500. The processing element may include I/O control logic and/or may include I/O control logic integrated with memory control logic. The processing element may also include one or more caches. In some embodiments, non-volatile memory (such as flash memory or fuses) may also be included on the chip with processor 1500.

FIG. 16 illustrates a computing system 1600 that is arranged in a point-to-point (PtP) configuration according to an embodiment. In particular, FIG. 16 shows a system where processors, memory, and input/output devices are interconnected by a number of point-to-point interfaces. Generally, one or more of the computing systems described herein may be configured in the same or similar manner as computing system 1500.

Processors 1670 and 1680 may also each include integrated memory controller logic (MC) 1672 and 1682 to communicate with memory elements 1632 and 1634. In alternative embodiments, memory controller logic 1672 and 1682 may be discrete logic separate from processors 1670 and 1680. Memory elements 1632 and/or 1634 may store various data to be used by processors 1670 and 1680 in achieving operations and functionality outlined herein.

Processors 1670 and 1680 may be any type of processor, such as those discussed in connection with other figures. Processors 1670 and 1680 may exchange data via a point-to-point (PtP) interface 1650 using point-to-point interface circuits 1678 and 1688, respectively. Processors 1670 and 1680 may each exchange data with a chipset 1690 via individual point-to-point interfaces 1652 and 1654 using point-to-point interface circuits 1676, 1686, 1694, and 1698. Chipset 1690 may also exchange data with a co-processor 1638, such as a high-performance graphics circuit, machine learning accelerator, or other co-processor 1638, via an interface 1639, which could be a PtP interface circuit. In alternative embodiments, any or all of the PtP links illustrated in FIG. 16 could be implemented as a multi-drop bus rather than a PtP link.

Chipset 1690 may be in communication with a bus 1620 via an interface circuit 1696. Bus 1620 may have one or more devices that communicate over it, such as a bus bridge 1618 and I/O devices 1616. Via a bus 1610, bus bridge 1618 may be in communication with other devices such as a user interface 1612 (such as a keyboard, mouse, touchscreen, or other input devices), communication devices 1626 (such as modems, network interface devices, or other types of communication devices that may communicate through a computer network 1660), audio I/O devices 1616, and/or a data storage device 1628. Data storage device 1628 may store code 1630, which may be executed by processors 1670 and/or 1680. In alternative embodiments, any portions of the bus architectures could be implemented with one or more PtP links.

The computer system depicted in FIG. 16 is a schematic illustration of an embodiment of a computing system that may be utilized to implement various embodiments discussed herein. It will be appreciated that various components of the system depicted in FIG. 16 may be combined in a system-on-a-chip (SoC) architecture or in any other suitable configuration capable of achieving the functionality and features of examples and implementations provided herein.

While some of the systems and solutions described and illustrated herein have been described as containing or being associated with a plurality of elements, not all elements explicitly illustrated or described may be utilized in each alternative implementation of the present disclosure. Additionally, one or more of the elements described herein may be located external to a system, while in other instances, certain elements may be included within or as a portion of one or more of the other described elements, as well as other elements not described in the illustrated implementation. Further, certain elements may be combined with other components, as well as used for alternative or additional purposes in addition to those purposes described herein.

Further, it should be appreciated that the examples presented above are nonlimiting examples provided merely for purposes of illustrating certain principles and features and not necessarily limiting or constraining the potential embodiments of the concepts described herein. For instance, a variety of different embodiments can be realized utilizing various combinations of the features and components described herein, including combinations realized through the various implementations of components described herein. Other implementations, features, and details should be appreciated from the contents of this Specification.

Although this disclosure has been described in terms of certain implementations and generally associated methods, alterations and permutations of these implementations and methods will be apparent to those skilled in the art. For example, the actions described herein can be performed in a different order than as described and still achieve the desirable results. As one example, the processes depicted in the accompanying figures do not necessarily require the particular order shown, or sequential order, to achieve the desired results. In certain implementations, multitasking and parallel processing may be advantageous. Additionally, other user interface layouts and functionality can be supported. Other variations are within the scope of the following claims.

In general, one aspect of the subject matter described in this specification can be embodied in methods and executed instructions that include or cause the actions of identifying a sample that includes software code, generating a control flow graph for each of a plurality of functions included in the sample, and identifying, in each of the functions, features corresponding to instances of a set of control flow fragment types. The identified features can be used to generate a feature set for the sample from the identified features

These and other embodiments can each optionally include one or more of the following features. The features identified for each of the functions can be combined to generate a consolidated string for the sample and the feature set can be generated from the consolidated string. A string can be generated for each of the functions, each string describing the respective features identified for the function. Combining the features can include identifying a call in a particular one of the plurality of functions to another one of the plurality of functions and replacing a portion of the string of the particular function referencing the other function with contents of the string of the other function. Identifying the features can include abstracting each of the strings of the functions such that only features of the set of control flow fragment types are described in the strings. The set of control flow fragment types can include memory accesses by the function and function calls by the function. Identifying the features can include identifying instances of memory accesses by each of the functions and identifying instances of function calls by each of the functions. The feature set can identify each of the features identified for each of the functions. The feature set can be an n-graph.

Further, these and other embodiments can each optionally include one or more of the following features. The feature set can be provided for use in classifying the sample. For instance, classifying the sample can include clustering the sample with other samples based on corresponding features of the samples. Classifying the sample can further include determining a set of features relevant to a cluster of samples. Classifying the sample can also include determining whether to classify the sample as malware and/or determining whether the sample is likely one of one or more families of malware. Identifying the features can include abstracting each of the control flow graphs such that only features of the set of control flow fragment types are described in the control flow graphs. A plurality of samples can be received, including the sample. In some cases, the plurality of samples can be received from a plurality of sources. The feature set can identify a subset of features identified in the control flow graphs of the functions of the sample. The subset of features can correspond to memory accesses and function calls in the sample code.

While this specification contains many specific implementation details, these should not be construed as limitations on the scope of any inventions or of what may be claimed, but rather as descriptions of features specific to particular embodiments of particular inventions. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

The following examples pertain to embodiments in accordance with this Specification. It will be understood that certain examples may be combined with certain other examples, in certain embodiments.

Example 1 includes a two-tier vapor chamber apparatus comprising: a sealed first cavity defined at least partially by a first metal wall and a second metal wall, wherein an internal pressure of the sealed first cavity is lower than an ambient pressure outside the sealed first cavity; and a sealed second cavity defined at least partially by a flat third metal wall and the second metal wall, wherein the second cavity comprises a liquid disposed therein and wick material coupled to an interior surface of the third wall.

Example 2 includes the subject matter of Example 1 and/or other Example(s), and optionally, wherein the sealed first cavity is disposed within the sealed second cavity.

Example 3 includes the subject matter of Example 1 or 2 and/or other Example(s), and optionally, wherein an internal pressure of the first cavity is below 0.1 torr.

Example 4 includes the subject matter of any one of Examples 1-3 and/or other Example(s), and optionally, further comprising a material within the first cavity having a thermal conductivity less than air.

Example 5 includes the subject matter of Example 4 and/or other Example(s), and optionally, wherein the material is an aerogel.

Example 6 includes the subject matter of any one of Examples 1-5 and/or other Example(s), and optionally, further comprising one or more support structures in the first cavity, the support structures in contact with the first metal wall and the second metal wall.

Example 7 includes the subject matter of Example 6 and/or other Example(s), and optionally, wherein the support structures are at least partially orthogonal to the first metal wall and second metal wall.

Example 8 includes the subject matter of Example 6 and/or other Example(s), and optionally, wherein the support structures are composed of one or more of plastic, graphite, metal, and composite material.

Example 9 includes the subject matter of any one of Examples 1-8 and/or other Example(s), and optionally, further comprising additional wick material coupled to an interior surface of the second wall.

Example 10 includes the subject matter of any one of Examples 1-9 and/or other Example(s), and optionally, wherein the wick material comprises sintered metal.

Example 11 includes the subject matter of Example 10 and/or other Example(s), and optionally, wherein the wick material comprises a first portion and a second portion, the sintered metal of the first portion having a higher porosity than the sintered metal of the second portion.

Example 12 includes the subject matter of Example 11 and/or other Example(s), and optionally, wherein the sintered metal of the first portion has a porosity between approximately 40% and 70%, and the sintered metal of the second portion has a porosity between approximately 30% and 50%.

Example 13 includes an apparatus comprising: a cooling system for a computer, wherein the cooling system comprises a two-tier vapor chamber, and the two-tier vapor chamber comprises: a sealed first cavity defined at least partially by a first metal wall and a second metal wall, wherein an internal pressure of the sealed first cavity is lower than an ambient pressure outside the sealed first cavity; and a sealed second cavity defined at least partially by a flat third metal wall and the second metal wall, wherein the second cavity comprises a liquid disposed therein and wick material coupled to an interior surface of the third wall.

Example 14 includes the subject matter of Example 13 and/or other Example(s), and optionally, wherein the sealed first cavity is disposed within the sealed second cavity.

Example 15 includes the subject matter of Example 13 or 14 and/or other Example(s), and optionally, wherein a cross-sectional area of the first cavity is one of substantially rectangular and substantially trapezoidal.

Example 16 includes the subject matter of Example 13 or 14 and/or other Example(s), and optionally, wherein a cross-sectional area of the second cavity is substantially rectangular.

Example 17 includes the subject matter of Example 13, 15, or 16 and/or other Example(s), and optionally, wherein a cross-sectional area of the first cavity is less than a cross-sectional area of the second cavity.

Example 18 includes the subject matter of any one of Examples 13-17 and/or other Example(s), and optionally, wherein the first wall comprises one of copper, titanium, and aluminum.

Example 19 includes the subject matter of any one of Examples 13-17 and/or other Example(s), and optionally, wherein the third wall comprises one of copper, titanium, and aluminum.

Example 20 includes a system comprising: a chip package comprising a processor; and a vapor chamber apparatus comprising: a first cavity defined at least partially by a first metal wall and a second metal wall, wherein an internal pressure of the first cavity is lower than an ambient pressure outside the first cavity; and a second cavity defined at least partially by a flat third metal wall and the second metal wall, wherein the second cavity comprises a liquid disposed therein wick material coupled to an interior surface of the third wall and the chip package is positioned such that it coupled to the flat third metal wall of the vapor chamber.

Example 21 includes the subject matter of Example 20 and/or other Example(s), and optionally, wherein the first cavity is disposed within the second cavity.

Example 22 includes the subject matter of Example 20 or 21 and/or other Example(s), and optionally, further comprising a heat exchanger coupled to the vapor chamber apparatus.

Example 23 includes the subject matter of any one of Examples 20-22 and/or other Example(s), and optionally, wherein the chip package comprises one of a central processing unit and a graphics processing unit.

Example 24 includes the subject matter of any one of Examples 20-23 and/or other Example(s), and optionally, further comprising: a printed circuit board housing the chip package, wherein the vapor chamber apparatus is coupled to the chip package on a surface of the chip package opposite the printed circuit board; and a top cover comprising glass, wherein the top cover and vapor chamber apparatus are positioned such that there is an air gap between an interior surface of the top cover and a surface of the vapor chamber apparatus opposite the chip package.

Example 25 includes the subject matter of any one of Examples 20-24 and/or other Example(s), and optionally, wherein the system is one of a mobile phone or tablet computer device.

Thus, particular embodiments of the subject matter have been described. Other embodiments are within the scope of the following claims. In some cases, the actions recited in the claims can be performed in a different order and still achieve desirable results. In addition, the processes depicted in the accompanying figures do not necessarily require the particular order shown, or sequential order, to achieve desirable results.

**Claims**

1. A two-tier vapor chamber apparatus comprising:

   a sealed first cavity defined at least partially by a first metal wall and a second metal wall, and
   a sealed second cavity defined at least partially by a flat third metal wall and the second metal wall, wherein the second cavity comprises a liquid disposed therein and wick material coupled to an interior surface of the third wall, the apparatus being **characterized in that** an internal pressure of the sealed first cavity is lower than an ambient pressure outside the sealed first cavity, and **in that** the internal pressure of the sealed first cavity is configured to be below 0.1 Torr.

2. The apparatus of claim 1, wherein the sealed first cavity is disposed within the sealed second cavity.

3. The apparatus of claim 2, further comprising one or more support structures in the first cavity, the support structures in contact with the first metal wall and the second metal wall.

4. The apparatus of claim 3, wherein the support structures are at least partially orthogonal to the first metal wall and second metal wall.

5. The apparatus of claim 3, wherein the support structures are composed of one or more of plastic, graphite, metal, and composite material.

6. The apparatus of any of claims 1-2, further comprising additional wick material coupled to an interior surface of the second wall.

7. The apparatus of any of claims 1-2, wherein the wick material comprises sintered metal.

8. The apparatus of claim 7, wherein the wick material comprises a first portion and a second portion, the sintered metal of the first portion having a higher porosity than the sintered metal of the second portion.

9. The apparatus of claim 8, wherein the sintered metal of the first portion has a porosity between approximately 40% and 70%, and the sintered metal of the second portion has a porosity between approximately 30% and 50%.

10. A system comprising:

a chip package comprising a processor; and
the vapor chamber apparatus of any of claims 1-9, wherein the chip package is positioned such that it is coupled to the flat third metal wall of the vapor chamber apparatus.

11. The system of claim 10, further comprising a heat exchanger coupled to the vapor chamber apparatus.

12. The system of claim 10 or 11, further comprising:

a printed circuit board housing the chip package, wherein the vapor chamber apparatus is coupled to the chip package on a surface of the chip package opposite the printed circuit board; and
a top cover comprising glass, wherein the top cover and vapor chamber apparatus are positioned such that there is an air gap between an interior surface of the top cover and a surface of the vapor chamber apparatus opposite the chip package.

**Patentansprüche**

1. Vorrichtung mit zweistufiger Dampfkammer, umfassend:

einen abgedichteten ersten Hohlraum, der wenigstens teilweise durch eine erste Metallwand und eine zweite Metallwand definiert wird, und
einen abgedichteten zweiten Hohlraum, der wenigstens teilweise durch eine flache dritte Metallwand und die zweite Metallwand definiert wird, wobei der zweite Hohlraum eine darin angeordnete Flüssigkeit und Dochtmaterial, das mit einer Innenfläche der dritten Wand gekoppelt ist, umfasst, wobei die Vorrichtung **dadurch gekennzeichnet ist, dass** ein Innendruck des abgedichteten ersten Hohlraums niedriger als ein Umgebungsdruck außerhalb des abgedichteten ersten Hohlraums ist, und dadurch, dass der Innendruck des abgedichteten ersten Hohlraums so ausgestaltet ist, dass er unter 0,1 Torr liegt.

2. Vorrichtung nach Anspruch 1, wobei der abgedichtete erste Hohlraum innerhalb des abgedichteten zweiten Hohlraums angeordnet ist.

3. Vorrichtung nach Anspruch 2, die ferner eine oder mehrere Stützstrukturen in dem ersten Hohlraum umfasst, wobei die Stützstrukturen mit der ersten Metallwand und der zweiten Metallwand in Kontakt stehen.

4. Vorrichtung nach Anspruch 3, wobei die Stützstrukturen wenigstens teilweise senkrecht zu der ersten Metallwand und der zweiten Metallwand sind.

5. Vorrichtung nach Anspruch 3, wobei die Stützstrukturen aus einem oder mehreren von Kunststoff, Graphit, Metall und Verbundmaterial zusammengesetzt sind.

6. Vorrichtung nach einem der Ansprüche 1-2, die ferner zusätzliches Dochtmaterial umfasst, das mit einer Innenfläche der zweiten Wand gekoppelt ist.

**7.** Vorrichtung nach einem der Ansprüche 1-2, wobei das Dochtmaterial gesintertes Metall umfasst.

**8.** Vorrichtung nach Anspruch 7, wobei das Dochtmaterial einen ersten Abschnitt und einen zweiten Abschnitt umfasst, wobei das gesinterte Metall des ersten Abschnitts eine höhere Porosität als das gesinterte Metall des zweiten Abschnitts aufweist.

**9.** Vorrichtung nach Anspruch 8, wobei das gesinterte Metall des ersten Abschnitts eine Porosität zwischen ungefähr 40 % und 70 % aufweist und das gesinterte Metall des zweiten Abschnitts eine Porosität zwischen ungefähr 30 % und 50 % aufweist.

**10.** System, das Folgendes umfasst:

ein Chipgehäuse, das einen Prozessor umfasst; und
die Dampfkammer-Vorrichtung nach einem der Ansprüche 1-9, wobei das Chipgehäuse derart angeordnet ist, dass es mit der flachen dritten Metallwand der Dampfkammer-Vorrichtung gekoppelt ist.

**11.** System nach Anspruch 10, das ferner einen Wärmetauscher umfasst, der mit der Dampfkammer-Vorrichtung gekoppelt ist.

**12.** System nach Anspruch 10 oder 11, das ferner Folgendes umfasst:

eine Leiterplatte, auf der das Chipgehäuse untergebracht ist, wobei die Dampfkammer-Vorrichtung auf einer Oberfläche des Chipgehäuses gegenüber der Leiterplatte mit dem Chipgehäuse gekoppelt ist; und
eine obere Abdeckung, die Glas umfasst, wobei die obere Abdeckung und die Dampfkammer-Vorrichtung derart angeordnet sind, dass ein Luftspalt zwischen einer Innenfläche der oberen Abdeckung und einer Oberfläche der Dampfkammer-Vorrichtung gegenüber dem Chipgehäuse vorhanden ist.

**Revendications**

**1.** Appareil à chambre de vapeur à deux niveaux comprenant :

une première cavité scellée définie au moins partiellement par une première paroi métallique et une deuxième paroi métallique, et
une deuxième cavité scellée définie au moins partiellement par une troisième paroi métallique plate et la deuxième paroi métallique, la deuxième cavité comprenant un liquide disposé à l'intérieur et un matériau de mèche couplé à une surface intérieure de la troisième paroi, l'appareil étant **caractérisé en ce qu'**une pression interne de la première cavité scellée est inférieure à une pression ambiante à l'extérieur de la première cavité scellée, et **en ce que** la pression interne de la première cavité scellée est configurée pour être inférieure à 0,1 Torr.

**2.** Appareil selon la revendication 1, la première cavité scellée étant disposée à l'intérieur de la deuxième cavité scellée.

**3.** Appareil selon la revendication 2, comprenant en outre une ou plusieurs structures de support dans la première cavité, les structures de support étant en contact avec la première paroi métallique et la deuxième paroi métallique.

**4.** Appareil selon la revendication 3, les structures de support étant au moins partiellement orthogonales à la première paroi métallique et à la deuxième paroi métallique.

**5.** Appareil selon la revendication 3, les structures de support étant composées d'un ou plusieurs matériaux parmi un plastique, le graphite, un métal et un matériau composite.

**6.** Appareil selon l'une quelconque des revendications 1 et 2, comprenant en outre un matériau de mèche supplémentaire couplé à une surface intérieure de la deuxième paroi.

**7.** Appareil selon l'une quelconque des revendications 1 et 2, le matériau de mèche comprenant du métal fritté.

**8.** Appareil selon la revendication 7, le matériau de mèche comprenant une première partie et une deuxième partie, le métal fritté de la première partie ayant une porosité plus élevée que le métal fritté de la deuxième partie.

**9.** Appareil selon la revendication 8, le métal fritté de la première partie ayant une porosité comprise entre environ 40 % et 70 %, et le métal fritté de la deuxième partie ayant une porosité comprise entre environ 30 % et 50 %.

**10.** Système comprenant :

un boîtier de puce comprenant un processeur ; et
l'appareil à chambre de vapeur selon l'une quelconque des revendications 1 à 9, le boîtier de puce étant positionné de manière à être couplé à la troisième paroi métallique plate de l'appareil à chambre de vapeur.

**11.** Système selon la revendication 10, comprenant en outre un échangeur de chaleur couplé à l'appareil à chambre de vapeur.

**12.** Procédé selon la revendication 10 ou 11, comportant en outre :

une carte de circuit imprimé abritant le boîtier de puce, l'appareil à chambre de vapeur étant couplé au boîtier de puce sur une surface du boîtier de puce opposée à la carte de circuit imprimé ; et
un couvercle supérieur comprenant du verre, le couvercle supérieur et l'appareil à chambre de vapeur étant positionnés de telle sorte qu'il existe un espace d'air entre une surface intérieure du couvercle supérieur et une surface de l'appareil à chambre de vapeur à l'opposé du boîtier de puce.

*100*

Top Layer *102*

↑ ↑ ↑ ↑ ↑  Heat          Air gap

Thermal Solution *104*

Chip Package *106*

PCB *108*

Bottom Layer *110*

# FIG. 1

FIG. 2

**FIG. 3A**

**FIG. 3B**

EP 3 974 758 B1

**FIG. 4A**

**FIG. 4B**

EP 3 974 758 B1

**FIG. 5A**

**FIG. 5B**

**FIG. 6**

EP 3 974 758 B1

Single Tier Apparatus

Two-Tier Apparatus

**FIG. 7A**

**FIG. 7B**

**Temporal variation of Tj (PL2-Single Core Turbo-12W)**

FIG. 8

EP 3 974 758 B1

FIG. 9

*1000*

1002 — | Extrude two-tier structure |

1004 — | Laser cut extruded apparatus to desired shape |

1006 — | Friction weld portions of cavities |

1008 — | Insert support structure material into top cavity |

1010 — | Insert wick material into bottom cavity |

1012 — | Prepare and seal top and bottom cavities |

## FIG. 10

1100

FIG. 11A

Extruded Apparatus

B

B

1100

1102

1104

1108

1106

1110

FIG. 11B

1100

FIG. 11C

FIG. 11D

Plastic/Copper/Titanium/ Graphite Support Pillars

**FIG. 11E**

Copper fibre or powdered sintered wick

**FIG. 11F**

EP 3 974 758 B1

EP 3 974 758 B1

1100

1114

**FIG. 11G**

**FIG. 12**

Single Tier Apparatus

Embedded Two-Tier Apparatus

**FIG. 13A**

**FIG. 13B**

Temporal variation of Tj PL2-22W

FIG. 14

**FIG. 15**

**FIG. 16**

EP 3 974 758 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- A Cascaded Multi-Core Vapor Chamber for Intra-Lid Heat Spreading in Heterogeneous Packages. **BANDYOPADHYAY SOUMYA et al.** 19TH IEEE INTERSOCIETY CONFERENCE ON THERMAL AND THERMOMECHANICAL PHENOMENA IN ELECTRONIC SYSTEMS (ITHERM). IEEE, 2020, 963-969